# EUROPÄISCHE PATENTSCHRIFT

(11) **EP 4 399 768 B1**
(45) Veröffentlichungstag und Bekanntmachung des Hinweises auf die Patenterteilung: **24.09.2025**
(21) Anmeldenummer: 22765785.5
(22) Anmeldetag: 16.08.2022
(51) Int. Cl.: H01R 13/641

(54) **PRÜFWERKZEUG UND VERFAHREN**
TESTING TOOL AND METHOD
OUTIL ET PROCÉDÉ DE TEST

(30) Priorität: 08.09.2021 DE 102021209891
(43) Veröffentlichungstag der Anmeldung: 17.07.2024
(73) Patentinhaber: Stellantis Auto SAS, 78300 Poissy (FR)
(72) Erfinder: BLOCHOWITZ, Joachim, 65428 Rüsselsheim am Main (DE); PASCHOLD, Martin, 65428 Rüsselsheim am Main (DE)
(74) Vertreter: ESIP
(86) Internationale Anmeldenummer: PCT/EP2022/072803
(87) Internationale Veröffentlichungsnummer: WO 2023/036563

(56) Entgegenhaltungen:
- EP-A1- 3 806 247
- DE-A1- 102016 000 981
- US-A1- 2018 254 584
- US-B2- 9 491 557

## Beschreibung

### Technisches Gebiet

Die Erfindung betrifft ein Prüfwerkzeug und Verfahren zum Prüfen einer Steckverbinder-Positionssicherung eines Steckverbinders.

### Stand der Technik

Aus der EP 2 831 959 B1 ist ein elektrischer Steckverbinder für einen Kabelbaum mit einem Steckverbinder-Positionssicherungs- (engl. Connector Position Assurance, CPA-) Element bekannt, das verschiebbar an einer Außenseite eines Steckverbindergehäuses angeordnet ist. Sobald der Steckverbinder mit einem entsprechenden Gegenstück vollständig verbunden ist, kann das CPA-Element von einer nicht-verriegelten Position in eine Verriegelungsposition verschoben werden. CPA-Elemente bieten somit einerseits eine visuelle Kontrollmöglichkeit, um zu überprüfen, ob ein Steckverbinder und sein entsprechendes Gegenstück vollständig zusammengesteckt sind. Ferner wird durch das CPA-Elemente eine mechanische Sicherung bereitgestellt, um ein nicht beabsichtigtes Trennen von Steckverbinder und Gegenstück zu verhindern.

In einer Montagelinie beispielsweise für die Fahrzeugfertigung muss jede Steckverbindung hinsichtlich korrekter Montage und Verrastung sicher geprüft werden. Die Überprüfung einer korrekten Steckverbindung kann durch einen Push/Pull-Tests erfolgen, der, gemäß etablierter Prozess Fehlermöglichkeits- und Einflussanalyse (engl. Process Failure Modes and Effects Analysis, PFMEA) Kriterien, durch einen zweiten Werker an einer Montagelinie erfolgen muss. Alternativ kann automatisiert eine visuelle Prüfung mittels Kamera und angeschlossener Bildverarbeitung erfolgen, indem beispielsweise optisch ermittelt wird, ob ein sich CPA-Element in seiner Verriegelungsposition befindet oder nicht.

Ein Problem besteht dabei darin, dass eine entsprechende Steckverbindung für eine Kontrolle schnell und einfach zugänglich sein muss. Nicht in allen Fertigungsprozessen steht ausreichend viel Bauraum zur Verfügung, der es einem zweiten Werker ermöglicht, den korrekten Sitz einer Steckverbindung mittels Push/Pull-Test zu prüfen. Auch bei einer kamerabasierten Prüfung ist eine montierte bzw. gesteckte Steckverbindung aus Steckverbinder und entsprechendem Gegenstück nicht immer ausreichend gut für eine visuelle Kontrolle einsehbar. Ferner liefert eine Kamera zwar grundsätzlich ein eindeutiges und gut zu dokumentierendes Ergebnis, jedoch können zum Beispiel aufgrund von Reflexionen, unterschiedliche Lichtverhältnisse (Blendungen, Schatten), verschmutzte Bauteile, etc. auch falsch negative Ergebnisse auftreten.

Aus der EP 3 806 247 A1 ist Verfahren zum Prüfen einer Verbindungsposition eines Steckverbinders bekannt, wobei eine maschinenlesbare visuelle Kennung durch einen Sensor nur dann abgetastet werden kann, wenn die Verbindungsposition korrekt ist.

Aus der US 9 491 557 B2 ist ein System und Verfahren für eine gesicherte Steckerverbindung bekannt, wobei eine korrekte Montage und Verrastung der Steckerverbindung bei einer Montage mittels eines Mikrofons akustisch erkannt wird.

Das Dokument DE 102016000981 A1 offenbart ein ähnliches System zur Überprüfung des korrekten Steckzustands eines Steckverbinders.

### Kurzbeschreibung der Erfindung

Vor diesem Hintergrund liegt der Erfindung die Aufgabe zugrunde, eine alternative Möglichkeit bereitzustellen, um eine korrekte Montage und Verrastung eines Steckverbinders mit einem Positionssicherungselement zuverlässig zu prüfen.

Vorgeschlagen wird dementsprechend ein Prüfwerkzeug gemäß dem Hauptanspruch sowie einem Verfahren gemäß dem Nebenanspruch. Weiterführende Ausgestaltungen sind Gegenstand der jeweils abhängigen Ansprüche.

Gemäß einem ersten Aspekt der Erfindung wird die Aufgabe gelöst durch ein Prüfwerkzeug zum Prüfen einer Steckverbinder-Positionssicherung eines Steckverbinders. Das Prüfwerkzeug umfassend ein Gehäusekörper, wobei an einer Gehäuseseite des Gehäusekörpers eine Vertiefung zum zumindest teilweisen Eintauchen bzw. Einschieben eines Steckergehäuses eines zu prüfenden Steckverbinders angeordnet ist. An einer unteren Seite der Vertiefung ist wenigstens eine erste Anlagefläche ausgebildet, an der ein korrespondierender Flächenabschnitt einer oberen Steckergehäuseseite eines zu prüfenden Steckverbinders zur Anlage gebracht werden kann, sofern sich ein Positionssicherungselement an der oberen Steckergehäuseseite des zu prüfenden Steckverbinders in einer Verriegelungsposition befindet. An der unteren Seite der Vertiefung ist ferner eine zweite Anlagefläche angeordnet, an der ein an einer oberen Steckergehäuseseite angeordnetes Positionssicherungselement eines zu prüfenden Steckverbinders zur Anlage gebracht werden kann, sofern sich das Positionssicherungselement nicht in einer Verriegelungsposition befindet. Die ersten Anlageflächen und die zweite Anlagefläche sind derart zueinander angeordnet, dass ein korrespondierender Flächenabschnitt einer oberen Steckergehäuseseite eines zu prüfenden Steckverbinders nicht mit den ersten Anlageflächen zur Anlage gebracht werden kann, während ein nicht in einer Verriegelungsposition befindliches Positionssicherungselement des zu prüfenden Steckverbinders an der zweiten Anlagefläche anliegt.

Eine Idee hinter der vorliegenden Erfindung ist, ein Prüfwerkzeug bereitzustellen, das eine Negativform eines zu prüfenden Steckverbinders bildet. Das Prüfwerkzeug passt dabei nur korrekt auf den zu prüfenden Steckverbinder, wenn dieser richtig auf dem Gegenstück positioniert ist und wenn sich das Positionssicherungselement in seiner Verriegelungsposition befindet. Gemäß einer Weiterbildung des Prüfwerkzeuges kann vorgesehen sein, dass an der wenigstens einer ersten Anlagefläche ein Anlagesensor angeordnet ist.

Somit kann durch Auflegen des Prüfwerkzeugs auf einen richtig montierten Steckverbinder mit einem verriegelten Positionssicherungselement ein elektrisches Signal erzeugt werden, dass von einer Montageliniensteuerung ausgewertet werden kann.

Gemäß einer Weiterbildung kann der Anlagesensor einen Mikroschalter umfassen.

Der Mikroschalter kann dabei innerhalb des Gehäusekörpers an der unteren Seite der Vertiefung angeordnet sein. Eine Schaltzunge des Mikroschalters kann durch eine Bohrung durch die untere Seite im Bereich der ersten Anlagefläche in die Vertiefung hineinragen und als Tastelement zum Detektieren eines anliegenden korrespondierenden Flächenabschnitts eines zu Prüfenden Steckverbinders dienen.

Gemäß einer Weiterbildung des Prüfwerkzeuges können zwei erste Anlageflächen mit jeweils einem Anlagesensor an der unteren Seite der Vertiefung ausgebildet sein.

Die zwei ersten Anlageflächen können vorzugsweise derart zueinander an der unteren Seite der Vertiefung platziert werden, dass diese nicht gleichzeitig von einem Finger eines Werkers berührt werden können. Dadurch wird eine fehlersichere Handhabbarkeit des Prüfwerkzeugs gewährleistet, da eine gleichzeitige Fehlauslösung beider Anlagesensoren zumindest erschwert wird.

Gemäß einer Weiterbildung des Prüfwerkzeug kann eine Kontur einer seitlichen Seite der Vertiefung an eine seitliche Kontur eines Steckergehäuses eines zu prüfenden Steckverbinders derart angepasst sein, dass die erste Anlagefläche beim Eintauchen des Steckergehäuses in die Vertiefung im Wesentlichen parallel zu einem jeweilig korrespondierenden Flächenabschnitt einer oberen Steckergehäuseseite ausgerichtet ist.

Dadurch wird gewährleistet, dass ein zu prüfender Steckverbinder beim Eintauchen in die Vertiefung nicht derart verkanten kann, dass ein Anlagesensor falsch ausgelöst werden kann.

Nach einem zweiten Aspekt der Erfindung wird die Aufgabe gelöst durch ein Verfahren zum Prüfen einer Steckverbinder-Positionssicherung eines Steckverbinders mit einem vorstehend beschriebenen Prüfwerkzeug. Das Prüfwerkzeug wird dabei auf den Steckverbinder aufgelegt, nachdem eine Steckverbindung zwischen dem Steckverbinder und einem Gegenstück hergestellt wurde. Wenigstens eine erste Anlagefläche an einer unteren Seite einer Vertiefung in einen Gehäusekörper des Prüfwerkzeuges wird mit einem korrespondierenden Flächenabschnitt einer oberen Steckergehäuseseite des Steckverbinders zur Anlage gebracht, wenn sich ein Positionssicherungselement an der oberen Steckergehäuseseite des Steckverbinders in einer Verriegelungsposition befindet. Eine zweite Anlagefläche an der unteren Seite der Vertiefung wird mit einem an einer oberen Steckergehäuseseite angeordneten Positionssicherungselement des Steckverbinders zur Anlage gebracht, wenn sich das Positionssicherungselement nicht in einer Verriegelungsposition befindet. Der korrespondierende Flächenabschnitt des Steckverbinders kann nicht mit den ersten Anlageflächen zur Anlage gebracht werden, wenn ein nicht in einer Verriegelungsposition befindliches Positionssicherungselement des Steckverbinders an der zweiten Anlagefläche anliegt.

Gemäß einer Weiterbildung des Verfahrens kann mit einem an der wenigstens eine erste Anlagefläche angeordneten Anlagesensor ein Signal erzeugt werden, sobald ein Anliegen der wenigstens eine erste Anlagefläche an einem korrespondierenden Flächenabschnitt der oberen Steckergehäuseseite des Steckverbinders erfasst wird.

Das erzeugte Signal kann an eine Montageliniensteuerung gesendet und von dieser ausgewertet werden. Somit können durch die Montageliniensteuerung nachfolgende Montageschritte auf einer Fertigungslinie freigegeben werden, wenn eine korrekte Montage und Verrastung des Steckverbinders mit einem entsprechenden Gegenstück signalisiert worden ist.

### Kurze Beschreibung der Zeichnungsfiguren

Weitere Merkmale und Einzelheiten ergeben sich aus der nachfolgenden Beschreibung, in der - gegebenenfalls unter Bezug auf die Zeichnung - zumindest ein Ausführungsbeispiel im Einzelnen beschrieben ist. Beschriebene und/oder bildlich dargestellte Merkmale bilden für sich oder in beliebiger, sinnvoller Kombination den Gegenstand, gegebenenfalls auch unabhängig von den Ansprüchen, und können insbesondere zusätzlich auch Gegenstand einer oder mehrerer separater Anmeldung/en sein. Gleiche, ähnliche und/oder funktions-gleiche Teile sind mit gleichen Bezugszeichen versehen. Dabei zeigen:
Figur 1 zeigt einen Steckverbinder mit einem Positionssicherungselement gemäß Stand der Technik;
Figur 2 zeigt eine perspektivische Ansicht eines erfindungsgemäßen Prüfwerkzeugs;
Figur 3 zeigt eine Aufsicht auf das erfindungsgemäße Prüfwerkzeug;
Figur 4 zeigt eine Schnittansicht durch das Prüfwerkzeug;
Figur 5 zeigt eine Schnittansicht durch das Prüfwerkzeug und durch einen zu prüfenden Steckverbinder mit einem nicht verriegelten CPA-Element;
Figur 6 zeigt eine Schnittansicht durch das Prüfwerkzeug und durch einen zu prüfenden Steckverbinder mit einem ordnungsgemäß verriegelten CPA-Element.

### Beschreibung der Ausführungsarten

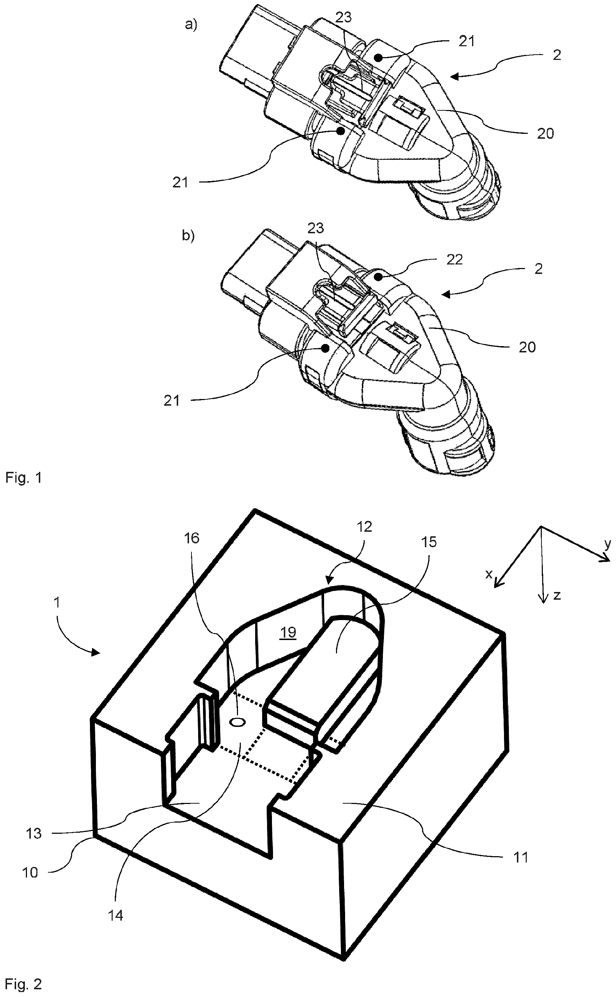

Die Figur 1 zeigt zwei Darstellungen eines Steckverbinders 2 mit einem Positionssicherungselement (CPA-Element) 23. Der Steckverbinder 2 besitzt ein Steckergehäuse 20 mit einer oberen Steckergehäuseseite 22. Das CPA-Element 23 ist an der oberen Steckergehäuseseite 22 verschiebbar angeordnet. Sobald der Steckverbinder 2 mit einem entsprechenden Gegenstück verbunden ist, erlaubt eine innere Mechanik, das CPA-Element 23 von einer nicht-verriegelten Position in eine Verriegelungsposition zu verschieben. In der Figur 1a ist der Steckverbinder 2 mit einem CPA-Element 23 dargestellt, das sich in einer nicht-verriegelten Position befindet. Der in der Figur 1b dargestellte Steckverbinder 2, dessen CPA-Element 23 sich in Verriegelungsposition befindet, ist mechanische gegen ein unbeabsichtigtes Trennen von einem in der Figur 1b nicht dargestellten Gegenstück gesichert. Das CPA-Element 23 ist parallel zu einer Steckrichtung des Steckverbinder 2 verschiebbar im Steckergehäuse 20 geführt.

Auf der oberen Steckergehäuseseite 22 sind zwei Flächenabschnitte 21 angeordnet, die sich zur Verschieberichtung seitlich neben dem CPA-Element 23 erstrecken.

In der Figur 2 ist eine perspektivische Ansicht eines erfindungsgemäßen Prüfwerkzeugs 1 zum Prüfen einer Steckverbinder-Positionssicherung eines Steckverbinders 2 dargestellt. Das Prüfwerkzeug 1 besitzt einen Gehäusekörper 10, wobei an einer Gehäuseseite 11 eine Vertiefung 12 ausgebildet ist. Die Vertiefung 12 ist derart ausgeformt, dass eine zumindest abschnittsweise geometrische Negativform eines zu prüfenden Steckverbinders 2 gebildet wird.

Das Prüfwerkzeug 1 kann zum Prüfen einer korrekten Steckverbindung auf den Steckverbinder 2 aufgelegt werden, so dass das Steckergehäuse 20 mit seiner oberen Steckergehäuseseite 22 voran in die Vertiefung 12 des Prüfwerkzeug 1 eintauchen kann.

An einer unteren Seite 13 der Vertiefung 12 ist zumindest eine erste Anlageflächen 14 zu erkennen, an der ein korrespondierender Flächenabschnitt 21 auf der oberen Steckergehäuseseite 22 eines zu prüfenden Steckverbinders 2 zur Anlage gebracht werden kann.

Innerhalb der erste Anlageflächen 14 ist ein Anlagesensor 16 angeordnet, mit dem eine anliegender korrespondierender Flächenabschnitt 21 eines zu prüfenden Steckverbinders 2 erfasst werden kann.

An der unteren Seite 13 der Vertiefung 12 ist ferner eine zweite Anlagefläche 15 vorgesehen, die bezüglich einer Eintauchrichtung z oberhalb der zumindest einen erste Anlageflächen 14 angeordnet ist.

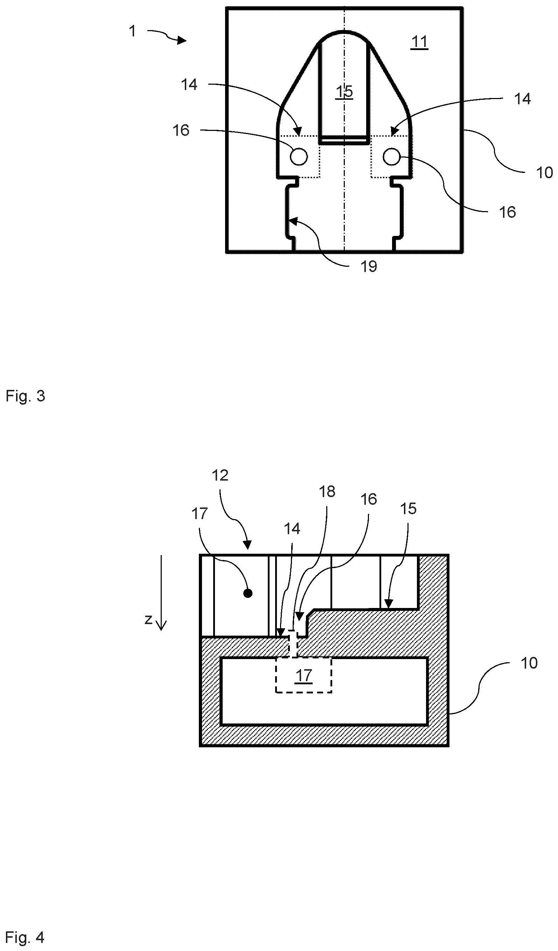

Wie aus der Figur 3 mit einer Aufsicht auf das Prüfwerkzeug 1 zu erkennen ist, weist die untere Seite 13 der Vertiefung 12 eine weitere erste Anlageflächen 14 auf, die in der perspektivischen Darstellung der Figur 2 größtenteils verdeckt dargestellt ist. In der weitern ersten Anlagefläche 14 ist ein weiterer Anlagesensor 16 angeordnet. Die Anzahl der in einem Prüfwerkzeug 1 vorgesehenen Anlagesensoren 16 kann an das Design eines jeweilig zu prüfenden Steckverbinders 2 angepasst werden. Vorteilhaft ist jedoch, wenigstens zwei erste Anlageflächen 14 mit jeweils einem Anlagesensor 16 in der Vertiefung 12 des Prüfwerkzeugs 1 vorzusehen. Durch eine geeignete Anordnung der zwei ersten Anlageflächen 14 mit den zugeordneten Anlagesensor 16 kann eine fehlersichere Handhabung des Prüfwerkzeugs 1 erzielt werden. Im Zusammenwirken mit der Geometrie des Prüfwerkzeugs 1 kann verhindert werden, dass beide Anlagesensor 16 beispielsweise durch einen Finger eines Werkers ausgelöst werden können.

In der Figur 4 zeigt eine Schnittdarstellung durch das Prüfwerkzeug 1. Die Anlagesensoren 16 können beispielsweise jeweils einen Mikroschalter 17 mit einer Schaltzunge 18 umfassen, wobei die Schaltzunge 18 durch den Gehäusekörper 10 geführt ist und an der unteren Seite 13 in die Vertiefung 12 hineinragt. Die ersten Anlageflächen 14 und die zweite Anlagefläche 15 sind in horizontal d.h. in Eintauchrichtung z der Vertiefung 12 beanstandet angeordnet.

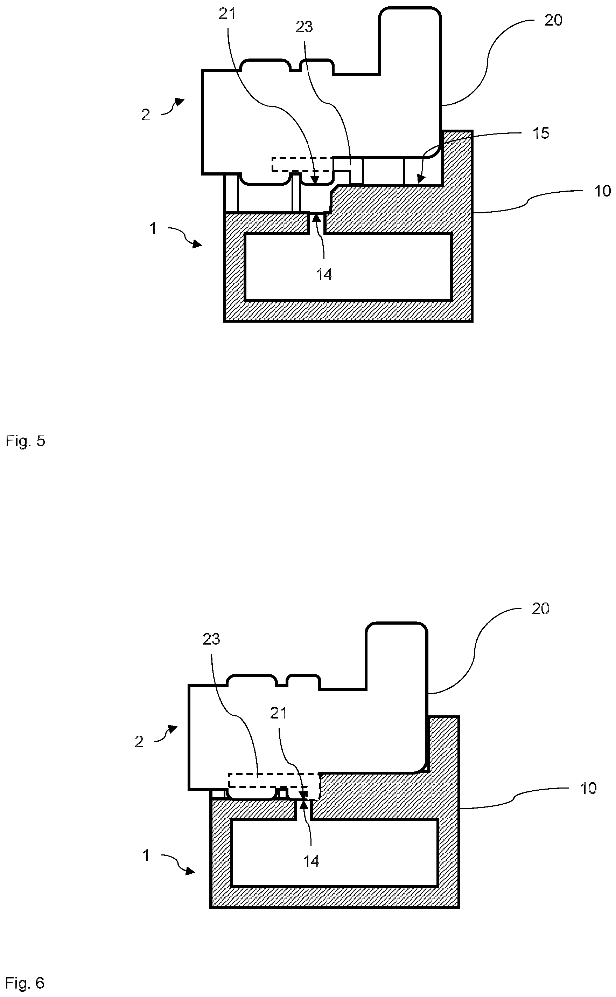

Nach dem eine zu prüfende Steckverbindung durch einstecken eines Steckverbinders 2 in ein entsprechendes Gegenstück hergestellt worden ist, kann das Prüfwerkzeug 1, gemäß den Schnittdarstellungen in den Figuren 5 und 6, auf den Steckverbinder 2 aufgelegt werden. Das Steckergehäuse 20 taucht folglich mit seiner oberen Steckergehäuseseite 22 vornan in Eintauchrichtung z in die Vertiefung 12 im Gehäusekörper 10 des Prüfwerkzeugs 1 ein.

Die seitlichen Seiten 19 der Vertiefung 12 im Gehäusekörper 10 sind derart an die seitlichen Konturen eines zu prüfenden Steckergehäuses 20 angepasst, dass die oberen Steckergehäuseseite 22 beim Eintauchen die Vertiefung 12 im Wesentlichen parallel zu der unteren Seite 13 der Vertiefung 13 geführt werden kann.

In der Figur 5 zeigt einen Steckverbinder 2, der bei einem Prüfvorgang nicht ordnungsgemäß Verriegelt ist. Das CPA-Element 23, das sich nicht in seiner Verriegelungsposition befindet, liegt nach dem Eintauchen des Steckergehäuses 20 in die Vertiefung 12 auf der zweiten Anlagefläche 15 auf. Die ersten Anlageflächen 14 kommen dadurch nicht mit den korrespondierenden Flächenabschnitten 21 auf oberen Steckergehäuseseite 22 zur Anlage. Da die Positionssicherung nicht ordnungsgemäß verriegelt ist, erfassen die Anlagesensoren 16 somit keinen anliegenden Steckverbinder 2.

Die Figur 6 zeigt einen Steckverbinder 2 mit einer ordnungsgemäß verriegelten Positionssicherung, nach dem der Steckverbinder 2 mit einem entsprechenden Gegenstück verbunden wurde. Das CPA-Element 23 befindet sich also in seiner Verriegelungsposition. Somit sind die ersten Anlageflächen 14 in der Vertiefung 12 und die korrespondierenden Flächenabschnitte 21 der oberen Steckergehäuseseite 22 eines zu prüfenden Steckverbinders 2 zur Anlage gebracht worden. Die Anlagesensoren 16 erfassen somit einen anliegenden Steckverbinder 2, dessen CPA-Element sich ins einer Verriegelungsposition befindet. Da sich ein CPA-Element nur bei einer ordnungsgemäß gesteckten Steckverbindung aktivieren lässt, kann durch die Anlagesensoren 16 eine korrektere Montage und Verrastung einer sicher erfasst werden.

Die in dem Prüfwerkzeug 1 eigebetteten Anlagesensoren 16 erzeugen bei Auflegen des Prüfwerkzeugs 1 auf den Steckverbinder 2 ein auswertbares Signal, dass an eine Montageliniensteuerung gesendet werden kann. Mit Hilfe eines empfangenen Signals können nachfolgende Montageschritte auf einer Fertigungslinie freigegeben werden.

Obwohl der Gegenstand im Detail durch Ausführungsbeispiele näher illustriert und erläutert wurde, so ist die Erfindung nicht durch die offenbarten Beispiele eingeschränkt und andere Variationen können vom Fachmann hieraus abgeleitet werden. Es ist daher klar, dass eine Vielzahl von Variationsmöglichkeiten existiert. Es ist ebenfalls klar, dass beispielhaft genannte Ausführungsformen nur Beispiele darstellen, die nicht in irgendeiner Weise als Begrenzung etwa des Schutzbereichs, der Anwendungsmöglichkeiten oder der Konfiguration der Erfindung aufzufassen sind. Vielmehr versetzen die vorhergehende Beschreibung und die Figurenbeschreibung den Fachmann in die Lage, die beispielhaften Ausführungsformen konkret umzusetzen, wobei der Fachmann in Kenntnis des offenbarten Erfindungsgedankens vielfältige Änderungen beispielsweise hinsichtlich der Funktion oder der Anordnung einzelner, in einer beispielhaften Ausführungsform genannter Elemente vornehmen kann, ohne den Schutzbereich zu verlassen, der durch die Ansprüche definiert wird.

### Liste der Bezugszeichen

- 1: Prüfwerkzeug
- 10: Gehäusekörper
- 11: Gehäuseseite
- 12: Vertiefung
- 13: unteren Seite
- 14: erste Anlagefläche
- 15: zweite Anlagefläche
- 16: Anlagesensor
- 17: Mikroschalter
- 18: Schaltzunge
- 19: seitliche Seite
- 2: Steckverbinder
- 20: Steckergehäuse
- 21: Flächenabschnitt
- 22: oberen Steckergehäuseseite
- 23: Positionssicherungselement

## Patentansprüche

1. Prüfwerkzeug zum Prüfen einer Steckverbinder-Positionssicherung eines Steckverbinders (2) umfassend einen Gehäusekörper (10), wobei an einer Gehäuseseite (11) des Gehäusekörpers (10) eine Vertiefung (12) zum zumindest teilweisen Eintauchen eines Steckergehäuses (20) eines zu prüfenden Steckverbinders (2) angeordnet ist, wobei an einer unteren Seite (13) der Vertiefung (12) wenigstens eine erste Anlagefläche (14) ausgebildet ist, an der ein korrespondierender Flächenabschnitt (21) einer oberen Steckergehäuseseite (22) eines zu prüfenden Steckverbinders (2) zur Anlage gebracht werden kann, sofern sich ein Positionssicherungselement (23) an der oberen Steckergehäuseseite (22) des zu prüfenden Steckverbinders (2) in einer Verriegelungsposition befindet, und wobei an der unteren Seite (13) der Vertiefung (12) ferner eine zweite Anlagefläche (15) angeordnet ist, an der ein an einer oberen Steckergehäuseseite (22) angeordnetes Positionssicherungselement (23) eines zu prüfenden Steckverbinders (2) zur Anlage gebracht werden kann, sofern sich das Positionssicherungselement (23) nicht in einer Verriegelungsposition befindet, und wobei die ersten Anlageflächen (14) und die zweite Anlagefläche (15) derart zueinander angeordnet sind, dass ein korrespondierender Flächenabschnitt (21) einer oberen Steckergehäuseseite (22) eines zu prüfenden Steckverbinders (2) nicht mit den ersten Anlageflächen (14) zur Anlage gebracht werden kann, während ein nicht in einer Verriegelungsposition befindliches Positionssicherungselement (23) des zu prüfenden Steckverbinders (2) an der zweiten Anlagefläche (15) anliegt.

2. Prüfwerkzeug gemäß vorstehendem Anspruch, wobei an der wenigstens einen ersten Anlagefläche (14) ein Anlagesensor (16) angeordnet ist.

3. Prüfwerkzeug gemäß vorstehendem Anspruch 2, wobei der Anlagesensor (16) einen Mikroschalter (17) umfasst.

4. Prüfwerkzeug gemäß einem der beiden vorstehenden Ansprüche 2 oder 3, wobei wenigsten zwei erste Anlagefläche (14) mit jeweils einem Anlagesensor (16) an der unteren Seite (13) der Vertiefung (12) ausgebildet sind.

5. Prüfwerkzeug gemäß einem der vorstehenden Ansprüche, wobei eine Kontur einer seitlichen Seite (19) der Vertiefung (12) an eine seitliche Kontur eines Steckergehäuses (20) eines zu prüfenden Steckverbinders (2) derart angepasst ist, dass die erste Anlagefläche (14) beim Eintauchen des Steckergehäuses (20) in die Vertiefung (12) im Wesentlichen parallel zu einem jeweilig korrespondierenden Flächenabschnitt (21) einer oberen Steckergehäuseseite (22) ausgerichtet ist.

6. Verfahren zum Prüfen einer Steckverbinder-Positionssicherung eines Steckverbinders (2) mit einem Prüfwerkzeug (1) gemäß einem der vorstehenden Ansprüche, wobei das Prüfwerkzeug (1) auf den Steckverbinder (2) aufgelegt wird, nachdem eine Steckverbindung zwischen dem Steckverbinder (2) und einem Gegenstück hergestellt wurde, wobei wenigstens eine erste Anlagefläche (14) an einer unteren Seite (13) einer Vertiefung (12) in einen Gehäusekörper (10) des Prüfwerkzeuges (1) mit einem korrespondierenden Flächenabschnitt (21) einer oberen Steckergehäuseseite (22) des Steckverbinders (2) zur Anlage gebracht wird, wenn sich ein Positionssicherungselement (23) an der oberen Steckergehäuseseite (22) des Steckverbinders (2) in einer Verriegelungsposition befindet, und wobei eine zweite Anlagefläche (15) an der unteren Seite (13) der Vertiefung (12) mit einem an einer oberen Steckergehäuseseite (22) angeordneten Positionssicherungselement (23) des Steckverbinders (2) zur Anlage gebracht wird, wenn sich das Positionssicherungselement (23) nicht in einer Verriegelungsposition befindet, und wobei der korrespondierender Flächenabschnitt (21) des Steckverbinders (2) nicht mit den ersten Anlageflächen (14) zur Anlage gebracht werden kann, wenn ein nicht in einer Verriegelungsposition befindliches Positionssicherungselement (23) des Steckverbinders (2) an der zweiten Anlagefläche (15) anliegt.

7. Verfahren gemäß dem vorstehenden Anspruch 6, wobei mit einem an der wenigstens eine erste Anlagefläche (14) angeordneten Anlagesensor (16) ein Signal erzeugt wird, sobald ein Anliegen der wenigstens eine erste Anlagefläche (14) an einem korrespondierenden Flächenabschnitt (21) der oberen Steckergehäuseseite (22) des Steckverbinders (2) erfasst wird.

## Claims

1. Test tool for testing a plug connector position securing of a plug connector (2) comprising a housing body (10), wherein on a housing side (11) of the housing body (10) a recess (12) for at least partially immersing a plug housing (20) a plug connector to be tested (2) is arranged, wherein on a lower side (13) of the recess (12) at least one first contact surface (14) is formed, on which a corresponding surface section (21) an upper plug housing side (22) a plug connector to be tested (2) can be brought into contact, if a position securing element (23) on the upper plug housing side (22) of the plug connector to be tested The invention relates to a locking position, wherein a second contact surface (15) is arranged on the lower side (13) of the recess (12), on which a position securing element (23) of a plug connector (2) to be tested, which is arranged on an upper plug housing side (22), can be brought into contact if the position securing element (23) is not in a locking position, and wherein the first contact surfaces (14) and the second contact surface (15) are arranged relative to one another in such a way that a corresponding surface section (21) of an upper plug housing side (22) of a plug connector (2) to be tested cannot be brought into contact with the first contact surfaces (14), while a position securing element (23) that is not in a locking position The plug connector (2) rests against the second contact surface (15).

2. Test tool according to the preceding claim 2, wherein a contact sensor (16) is arranged on the at least one first contact surface (14).

3. Test tool according to claim 2, wherein the contact sensor (16) comprises a microswitch (17).

4. Test tool according to one of the two preceding claims 2 or 3, wherein at least two first contact surfaces (14) are formed with a respective contact sensor (16) on the lower side (13) of the depression (12).

5. Testing tool according to one of the preceding claims, wherein a contour of a lateral side (19) of the recess (12) is matched to a lateral contour of a plug housing (20) of a plug connector (2) to be tested in such a way that the first contact surface (14) is orientated substantially parallel to a respective corresponding surface section (21) of an upper plug housing side (22) when the plug housing (20) is immersed in the recess (12).

6. Method of testing a connector position lock of a connector (2) with a testing tool (1) according to any one of the preceding claims, wherein the testing tool (1) is placed on the connector (2) after a plug connection between the connector (2) and a counterpart has been made, wherein at least a first abutment surface (14) on a lower side (13) of a recess (12) in a housing body (10) of the testing tool (1) with a corresponding surface portion (21) of an upper connector housing side (22) of the connector (2) is brought into abutment when a position lock element (23) on the upper connector housing side (22) of the connector (2) is in a locked position, and wherein a second abutment surface is (15) on the lower side (13) of the recess (12) with a on an upper plug housing side (22) position securing element arranged (23) of the plug connector (2) when the position securing element (23) is not in a locking position, and wherein the corresponding surface section (21) of the plug connector (2) with the first contact surfaces (14) cannot be brought into contact when a not in a locking position securing element (23) of the plug connector (2) on the second contact surface (15) rests.

7. Method according to the preceding claim 6, wherein a signal is generated by means of an abutment sensor (16) arranged on the at least one first abutment surface (14) as soon as an abutment of the at least one first abutment surface (14) on a corresponding surface section (21) of the upper plug housing side (22) of the plug connector (2) is detected.

## Revendications

1. Outil d'essai pour l'essai d'une sécurité de position d'un connecteur enfichable (2) comprenant un corps de boîtier (10), un évidement (12) pour l'immersion au moins partielle d'un boîtier de connecteur (20) d'un connecteur enfichable (2) à tester étant disposé sur un côté de boîtier (11) du corps de boîtier (10), au moins une première surface d'appui (14) étant formée sur un côté inférieur (13) de l'évidement (12), sur laquelle est formée une partie de surface correspondante (21) d'un connecteur supérieur Le côté de boîtier de fiche (22) d'un connecteur à tester (2) peut être mis en contact, pour autant qu'un élément de sécurité de position (23) se trouve dans une position de verrouillage sur le côté supérieur de boîtier de fiche (22) du connecteur à tester (2), et qu'une deuxième surface d'appui (15) est en outre disposée sur le côté inférieur (13) de l'évidement (12), sur laquelle un élément de sécurité de position (23) d'un connecteur à tester (2), disposé sur un côté supérieur de boîtier de fiche (22), est amené (2) Dans la mesure où l'élément de fixation de position (23) ne se trouve pas dans une position de verrouillage, les premières surfaces d'appui (14) et la deuxième surface d'appui (15) sont disposées l'une par rapport à l'autre de telle sorte qu'une partie de surface correspondante (21) d'un côté supérieur (22) du boîtier de fiche d'un connecteur à tester (2) ne puisse pas être mise en appui contre les premières surfaces d'appui (14), tandis qu'un élément de fixation de position (23) du connecteur à tester (2) ne se trouvant pas dans une position de verrouillage ne puisse pas être mis en appui contre la deuxième surface d'appui (15).

2. Outil d'essai selon la revendication 2, dans lequel un capteur d'appui (16) est disposé sur ladite au moins une première surface d'appui (14).

3. Outil d'essai selon la revendication 2, dans lequel le capteur d'application (16) comprend un micro-interrupteur (17).

4. Outil d'essai selon l'une des deux revendications précédentes 2 ou 3, dans lequel au moins deux premières surfaces d'appui (14) sont formées avec respectivement un capteur d'appui (16) sur le côté inférieur (13) de la cavité (12).

5. Outil de test selon l'une quelconque des revendications précédentes, dans lequel un contour d'un côté latéral (19) de la cavité (12) est adapté à un contour latéral d'un boîtier de fiche (20) d'un connecteur à tester (2) de telle sorte que la première surface d'appui (14), lors de l'immersion du boîtier de fiche (20) dans la cavité (12), est orientée sensiblement parallèlement à une partie de surface correspondante respective (21) d'un côté supérieur de boîtier de fiche (22).

6. Procédé de test d'une sécurité de position de connecteur d'un connecteur (2) avec un outil de test (1) selon l'une quelconque des revendications précédentes, dans lequel l'outil de test (1) est posé sur le connecteur (2) après qu'une connexion par enfichage a été établie entre le connecteur (2) et une pièce complémentaire, au moins une première surface d'appui (14) sur un côté inférieur (13) d'un évidement (12) dans un corps de boîtier (10) de l'outil de test (1) avec une partie de surface correspondante (21) d'un côté supérieur de boîtier de connecteur (22) du Un connecteur (2) est mis en contact lorsqu'un élément de fixation de position (23) est dans une position de verrouillage sur le côté supérieur (22) du boîtier de connecteur (2), et une seconde surface d'appui (15) est mise en contact sur le côté inférieur (13) de l'évidement (12) avec un élément de fixation de position (23) du connecteur (2) disposé sur un côté supérieur (22) du boîtier de connecteur lorsque l'élément de fixation de position (23) n'est pas dans une position de verrouillage, et dans lequel le Une partie de surface correspondante (21) du connecteur enfichable (2) ne peut pas être mise en contact avec les premières surfaces d'appui (14) lorsqu'un élément de sécurité de position (23) du connecteur enfichable (2), qui n'est pas dans une position de verrouillage, est en contact avec la seconde surface d'appui (15).

7. Procédé selon la revendication 6, dans lequel un signal est généré avec un capteur d'application (16) disposé sur la première surface d'appui (14) au nombre d'au moins une dès qu'une application de la première surface d'appui (14) au nombre d'au moins une sur une partie de surface correspondante (21) du côté supérieur (22) du boîtier de fiche du connecteur (2) est détectée.
